Europäisches Patentamt

European Patent Office

Office européen des brevets

(11) Publication number : 0 535 823 A1

# (12) EUROPEAN PATENT APPLICATION

(21) Application number : 92308386.9

(22) Date of filing : 15.09.92

(51) Int. Cl.⁵ : **C23C 14/20**

(30) Priority : 02.10.91 US 771036

(43) Date of publication of application :
07.04.93 Bulletin 93/14

(84) Designated Contracting States :
DE FR GB IT

(71) Applicant : **MINNESOTA MINING AND MANUFACTURING COMPANY**
3M Center, P.O. Box 33427
St. Paul, Minnesota 55133-3427 (US)

(72) Inventor : **Koskenmaki, David C., c/o Minnesota Mining and Manufact. Co., 2501 Hudson Road, P.O. Box 33427
St. Paul, Minnesota 55133-3427 (US)**
Inventor : **Calhoun, Clyde D., c/o Minnesota Mining and Manufact. Co., 2501 Hudson Road, P.O. Box 33427
St. Paul, Minnesota 55133-3427 (US)**

(74) Representative : **Baillie, Iain Cameron et al c/o Ladas & Parry, Altheimer Eck 2
W-8000 München 2 (DE)**

(54) Thin conductive metal films having a random lacework pattern.

(57) The present invention provides an electrically conductive metal/polymer composite wherein the metal layer is of a random lacework pattern, and a method of forming a transparent, electrically conductive, metal/polymer composite by providing a thin sheet-like polymeric substrate having a glass transition temperature, $T_g$, and at least one deposition surface, a metal layer on at least one deposition surface of the sheet-like polymeric substrate, the metal having a melting temperature of greater than the $T_g$ of the polymeric substrate. The metal layer and the polymeric substrate are stretched at a temperature above the melting point of the metal, wherein upon stretching, the metal layer forms a random lacework pattern, including a plurality of core portions interconnected with fingers or rivulets. The random lacework pattern defines a plurality of microscopic voids that permit the transmission of light therethrough. The random lacework pattern retains electrical conductivity in the plane of the metal layer and polymeric substrate.

FIG. 1

EP 0 535 823 A1

## Technical Field

The present invention relates to a method for forming a thin conductive metal film having a random lacework pattern, and particularly to transparent metal/polymer composites including such a conductive metal film.

## Background

Composites of electrically conductive metal films and polymers have a number of uses, including solar thermal energy conversion, solar photovoltaic conversion, solar high power laser technology, photocathodes in photoelectrical/chemical cells, as surface layers in electroluminescent applications, in electromagnetic shielding, and in other related and unrelated applications.

Such composites are particularly useful when the composite is both transparent and conductive. Thin metal oxide films, such as indium oxide and indium-tin oxide, are known to be optically transparent and electrically conductive. Indium oxide and indium-tin oxide can be formed into thin layers having low electrical resistance and high optical transparency. Such films can be made, for example, by magnetron sputtering or by evaporating indium or indium-tin onto a substrate in an atmosphere containing carefully controlled amounts of oxygen and argon. However, these processes are very slow and difficult to control, and therefore, can be quite expensive.

Also, while such prior art metal oxide films are both transparent and electrically conductive, they are not known to be stretchable while retaining conductivity in the plane of the film. Stretching a polymeric film may be desirable for a number of reasons, including to impart strength to the film, either uniaxially or biaxially. Accordingly, it would be desirable to be able to stretch a polymeric film composite while retaining electrical conductivity and transparency in a surface layer.

It may also be desirable to provide a polymer sheet that is electrically conductive only in certain regions or portions of the sheet. It would be particularly desirable to provide a conductive layer on a polymeric substrate that retains conductivity only in desired regions or portions, after stretching.

Therefore, there is a need for a thin conductive film that is adhered to a polymeric substrate. The film is preferably transparent, or at least translucent. There is a further need for a coated polymeric film that includes electrically conductive regions or portions found at desired locations on the surface of a polymer, with other portions or regions being non-conductive. It is preferable that the entire composite be transparent or translucent. Accordingly, the present invention provides a process for forming a transparent, electrically conductive metal/polymer composite that includes a thin conductive metal film having a random lacework pattern that provides electrical conductivity in the plane of the polymeric substrate. The conductive metal film is in the form of a random lacework pattern that is also transparent or translucent.

## SUMMARY OF THE INVENTION

The present invention provides a method of forming a transparent, electrically conductive, metal/polymer composite comprising the steps, of providing a thin sheet-like polymeric substrate having a glass transition temperature, $T_g$, and at least one deposition surface, a metal layer on the at least one deposition surface of the sheet-like polymeric substrate, the metal having a melting temperature of greater than the $T_g$ of the polymeric substrate, and preferably greater than the blocking or tacky temperature of the polymer. As used herein, the "blocking" or "tacky" temperature of a polymer is a temperature at which the polymer sticks to itself when rolled up. It is a temperature which, for an amorphous polymer, includes the rubbery plateau and the rubbery flow temperatures. The metal layer is conductive in the plane of the polymeric substrate and metal layer. The metal layer and polymeric substrate are stretched at a temperature above the melting point of the metal, wherein upon stretching, the metal layer forms a random lacework pattern, including a plurality of core portions interconnected with narrow fingers or rivulets. The random lacework pattern defines a plurality of microscopic voids that permit the transmission of light therethrough. The random lacework pattern retains electrical conductivity in the plane of the metal layer and polymeric substrate.

To lower the melting point of the metal layer, it is preferred that the metal layer comprise more than one metal, i.e., that the metal layer be a metal alloy. It is further preferred that stretching occur at a temperature above the liquidus temperature of the alloy. It is also preferred that the alloy have a composition with a melting temperature range, as defined by the difference between the liquidus temperature and the solidus temperature, of about 20°C or less, and preferably about 10°C or less. Alloys with such narrow melting temperature ranges typically have compositions near eutectic compositions, near the component elemental metals, or near intermetallic compounds. Preferably the metal alloy comprises two or more metals selected from the group consisting of indium, tin, bismuth, and lead. The metal alloy may further include minor amounts of a higher melting point metal selected from the group consisting of zinc, aluminum, silver and copper.

Electrically conductive metal/polymer composites of the present invention that are made by the above method comprise a sheet-like polymeric substrate having a glass transition temperature, $T_g$, and at least one deposition surface, and a metal layer, preferably a metal alloy, provided on at least one of the deposition surfaces. The metal layer has a random lacework pattern that includes a plurality of core portions interconnected by a plurality of rivulet portions, thereby defining a plurality of voids therebetween. The transparent voids preferably comprise a sufficient portion of the deposition surface so that the metal layer is at least translucent, and preferably substantially transparent on a macro-scale.

Brief Description of the Drawings

Fig. 1 is a photomicrograph of a tin-indium lacework on PET, with the dark areas being the metal and the light areas being the voids.
Fig. 2 is a plot of sheet resistivity (ohms/square) on the X-axis versus percent void area on the Y-axis.

Detailed Description

The present invention provides a method by which an electrically conductive metal film having a random lacework configuration, can be formed on the surface of a polymer. The present invention also provides a method by which an electrically conductive film can be provided only in desired regions or portions of a polymeric surface.

The process includes coating a sheet-like polymeric substrate with a low melting point metal or metal alloy, followed by heating and stretching the polymer at a temperature above the melting point of the metal. During the stretching process, the metal layer does not bead up, but instead forms a lacework pattern having a plurality of core portions connected by a plurality of narrow fingers or rivulet portions that provide physical and electrical continuity between the core portions. A large number of transparent voids are defined by the lacework structure permitting transmission of light through the stretched metal lacework pattern. The size and spacing of the core portions and finger portions is determined by processing parameters and component selection parameters.

First, the metal or metal alloy should be in a liquid state during the stretching of the polymeric substrate. Solid regions present during stretching, including oxide skin formed on the surface of the liquid metal, tend to cause larger core regions and fewer finger or rivulet portions. If core portions are not connected by finger regions, then the desired electrical conductivity is lost. Thus, while some solid may be tolerated, too much solid or oxide skin may result in large voids without the desired interconnecting finger portions.

The metal or metal alloy selected must have a melting temperature that is sufficiently low so that the polymer is not degraded at the temperature of stretching. For this reason, low melting point metals, such as indium, tin, bismuth, and lead, are preferred. The relative composition of an alloy may be important as is discussed further below.

The eutectic compositions of alloys of indium, tin, bismuth and lead can have melting temperatures as low as 50° to 60°C. The metals themselves melt at 271°C (bismuth); 157°C (indium); 232°C (tin); and 327°C (lead). Minor amounts of higher melting point metals, such as zinc, aluminum, silver, and copper can be added, as desired. Examples of preferred eutectics include tin-indium, near 117°C; bismuth-indium, near 72°C; and bismuth-lead, near 125°C.

Another important parameter is the adhesive or attractive forces between the metal and the polymer during stretching. To prevent beading up of the metal on the surface of the polymeric substrate, the polymer must be sufficiently wet by the liquid metal so that the liquid metal flows with the polymer during stretching, rather than beading up. A polymer should be stretched at a temperature above its $T_g$, and with certain polymers, at a temperature at or above the tacky or blocking temperature. For some polymers the tacky or blocking temperature may be relatively near the $T_g$, and in other polymers it may be about 30°C to 60°C above the $T_g$. The blocking or tacky temperature of an amorphous polymer includes the rubbery plateau and the rubbery flow temperatures, see L.H. Sperling, Introduction to Physical Polymer Science, John Wiley (1986) p. 8.

It also appears that the softness or viscosity of the polymer has an effect on how the metal stretches. If the viscosity of the polymer is too low, as may occur at temperatures well above the $T_g$ of the polymer, the polymer at the polymer-metal interface may not be sufficiently stiff to overcome the natural tendency of the metal to lower its surface energy by beading up. During the process of forming a bead, the metal typically will not debond from the polymer, but instead the metal will pull the polymer at the metal-polymer interface along with it.

It appears that in many metal/polymer systems, there needs to be a good match between the softening or tacky temperature of the polymer, and the melting temperature of the metal. If the melting temperature of the metal is too low relative to the softening point of the polymer, the metal may bead up without wetting the polymer. If, on the other hand, the polymer softens at a temperature too low relative to the melting temperature of the metal, the polymer will not have sufficient stiffness to prevent the localized flowing of the soft polymer to accommodate the tendency of the metal to form discrete beads or voids rather than the desirable connecting network.

Desirable combinations of polymer and metals include PET with a coating of indium-tin eutectic alloy, PET with a coating of bismuth-lead eutectic alloy, and polypropylene with a coating of pure indium. Other polymeric films that have the desired characteristics described herein may also be used. The thickness of the film is typically about 0.1 to 2 μm. Preferably, the thickness of the metal film before stretching is 0.2 to 0.6 μm. The polymer may typically be stretched biaxially over a period of about to 60 seconds to values of about 2 to 2.5 times its initial length in each direction for a total increase in surface area of about 400 to 625 percent. Typically, beyond this degree of stretching, the electrical resistivity increases catastrophically as the fingers of metal in the lacework become discontinuous. Beyond about 70 to 80 percent void space between the interconnecting fingers the electrical resistivity increases rapidly.

## EXAMPLE 1

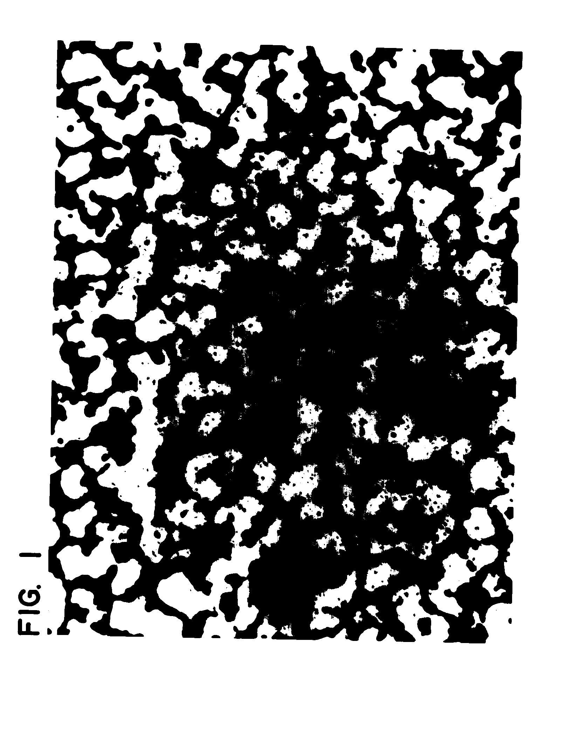

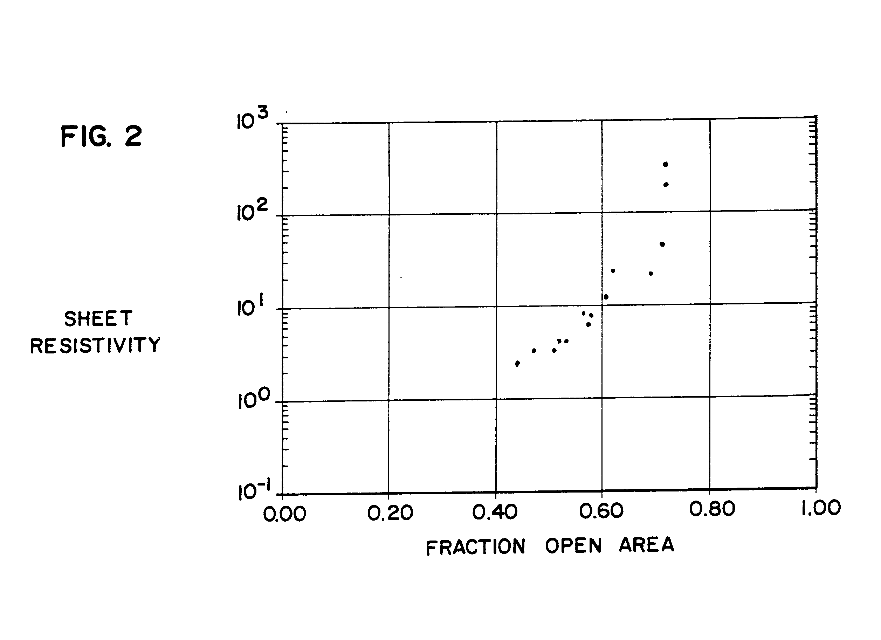

A tin-indium alloy was coated onto a cast polyester film 0.275 mm thick and 20 cm wide, using electron beam evaporation in a vacuum web coater. The electron beam source and power supply were manufactured by Airco Temescal of Berkeley, California. The power supply is a model CV-14. The vacuum chamber is a Varian Model 3125. The starting material in the electron beam hearth was 42 grams indium and 173 grams tin. The hearth was mounted 25 cm under the web. The web was driven by contacting a 40 cm diameter chill drum. The electron beam voltage and current was 9.4 volts and 0.12 ampere, respectively. Ten meters of web were coated using a web rate of 1.5 m/min. A metal alloy coating 0.5 μm thick of varying composition was formed on the PET, with the alloy increasingly rich in tin downweb. An 11 cm by 11 cm sample was cut from the web at the eutectic composition (48 wt% tin). This sample was heated to 125° C and biaxially stretched 2.5 times its original length in each direction over a period of 45 seconds in a film stretcher manufactured by T. M. Long Co., Inc., Somerville, N.J. The sample did not stretch uniformly, with portions that varied in thickness from 0.04 mm near the center of the sample to 0.07 mm near the edge. Eighteen samples, 7 mm by 7 mm, were cut from the stretched web and their sheet resistivities and void areas were measured. The void areas were measured using a Cambridge Instruments Quantimet 570 image analyzer using a magnification of 500 X. These void areas give a measure of the maximum light transmittance through the sample, not taking into account the reflectance and absorption of light due to the PET substrate. The sheet resistivity was measured using a probe consisting of two parallel bars 6 mm long and spaced 6 mm apart. A 500 X photomicrograph of one sample having a sheet resistivity of 4.2 ohms/square and a void area of 52 percent is shown in Figure 1. A plot of the void area versus resistivity of the various samples is shown in Figure 2. A summary of the data is given in Table 1. In Table 1, the thickness ratio is the final thickness (after stretching) of the polymer divided by the thickness before stretching.

## TABLE 1

| Thickness Ratio | Resistivity (Ohms/square) | Percent Void Area |
|---|---:|---:|
| 0.16 | 320 | 72 |
| 0.17 | 191 | 72 |
| 0.17 | 44 | 71 |
| 0.18 | 21 | 69 |
| 0.18 | 23 | 62 |
| 0.18 | 12 | 61 |
| 0.18 | 7.8 | 58 |
| 0.18 | 6.3 | 57 |
| 0.19 | 8.3 | 57 |
| 0.19 | 4.1 | 53 |
| 0.19 | 4.2 | 52 |
| 0.19 | 3.3 | 51 |
| 0.19 | 3.3 | 47 |
| 0.20 | 2.5 | 44 |
| 0.21 | 2.4 | 44 |
| 1.0 | 0.1 | 0 |

EXAMPLES 2-10

Examples 2-10 represent metal/polymer composites of the invention, and include a range of bismuth-indium and tin-indium alloys. These alloys form eutectics with melting temperatures as low as 72° and 117°C respectively. The metals themselves melt at 271°C (bismuth), 157°C (indium), and 232°C (tin), so a range of liquidus temperatures are possible.

The metal was evaporated onto a moving web of 250 μm thick cast polyester film using an electron beam to form a metal coating thickness of 0.5 to 1 μm under conditions similar to Example 1. Because the vapor pressures of the component metals differ, the composition in the metal coating varied with time as the more volatile metals were more quickly depleted. In this way, a range of compositions with varying melting points were available for study. The resulting metal coated polyester films were then heated to 130°C and stretched biaxially in a T. M. Long stretcher up to 2.4 times their original length in each direction. During stretching the polyester films were reduced in thickness by factors of 4 to 6, from 250 μm to 62.5 μm or 43 μm, respectively. Beyond this amount of stretch, the fingers of metal between the core portions no longer stretched far enough to provide a continuous path between the core portions, and therefore electrical continuity was lost. A summary of the various properties for Examples 2-10 is given in Table 2. In Table 2, the thickness ratio is the final thickness (after stretching) of the polyester film divided by the thickness before stretching.

**TABLE 2**

| Ex. | Composition (wt%) | Thickness Ratio | Resistivity (ohms/square) | % Void Area |
|---|---|---|---|---|
| 2 | 12 Bi, 77 In, 11 Sn | 0.16 | 3.3 | 45 |
| 3 | 6 Bi, 82 In, 12 Sn | 0.25 | 1.6 | 30 |
| 4 | 2 Bi, 84 In, 14 Sn | 0.19 | 1.0 | 35 |
| 5 | 2 Bi, 84 In, 15 Sn | 0.19 | 3.0 | 45 |
| 6 | 1 Bi, 76 In, 23 Sn | 0.26 | 4.7 | 45 |
| 7 | 1 Bi, 59 In, 39 Sn | 0.15 | 15 | 55 |
| 8 | 2 Bi, 59 In, 39 Sn | 0.16 | 8.6 | 50 |
| 9 | 2 Bi, 54 In, 44 Sn | 0.19 | 14 | 60 |
| 10 | 3 Bi, 44 In, 52 Sn, 1 Cu | 0.17 | 54 | 61 |

**EXAMPLE 11**

A bismuth-lead alloy was evaporated onto 0.275 mm thick cast PET which had several 13 cm by 13 cm by 0.05 mm squares of EAA (Ethylene acrylic acid) affixed to the PET with tape. The evaporation conditions

were similar to those of Example 1, except that the hearth was loaded with 93.5 g Bi and 115 g Pb. Two samples having an alloy coating of composition 60 wt% Bi, one sample deposited on cast PET, and one sample deposited on EAA coated PET, were stretched in a T. M. Long film stretcher at 140°C. Several 7 mm by 7 mm samples were cut out of the stretched samples and the resistivity and void area were measured. The samples with the metal coating on the EAA showed no electrical conductivity, and were found to have discrete metal beads by optical microscopic observation. The samples in which the metal coating was deposited directly onto cast PET were found to have a lacework microstructure by optical microscopy. In general, the Bi-Pb samples were not as conductive as InSn samples with the same amount of void area. Sheet resistivity for the PET region was typically 100 ohms/square at 50% void area.

## EXAMPLE 12

Pure indium metal was evaporated onto 0.29 mm thick by 20 cm wide polypropylene under conditions similar to Example 1, except that the electron beam current was 0.08 ampere and the hearth contained 200 g of pure indium. Samples were cut out and stretched in a similar manner to Example 1, except that the T. M. Long film stretcher was set to heat the samples to 165°C. The samples were biaxially stretched 150 percent in both directions. A typical stretched sample had a resistivity of 50 ohms/square at 40% void area.

## Claims

1.  An electrically conductive metal/polymer composite comprising:
    (a) a sheet-like polymeric substrate comprising a copolymer that includes an amorphous polymer, said substrate having a thickness of about 10 $\mu$m to 1,000 $\mu$m, a glass transition temperature, $T_g$, and at least one deposition surface;
    (b) a metal layer provided on at least one deposition surface of said sheet-like polymeric substrate, said metal layer comprising an alloy containing two or more metals selected from the group consisting of indium, tin, bismuth, and lead, having a thickness of about 0.05 $\mu$m to 5 $\mu$m, and a melting point or liquidus greater than the $T_g$ of said polymeric substrate, said metal layer having a random lacework pattern, including a plurality of core portions interconnected by a plurality of rivulet portions, said lacework pattern defining a plurality of transparent voids therebetween, said transparent voids permitting the transmissions of light therethrough, said metal layer being electrically conductive in the plane of the polymeric substrate and metal layer.

2.  The composite of claim 1 wherein said alloy comprises 40 to 70 percent by weight indium and 60 to 30 percent by weight of tin.

3.  The composite of claim 1 said metal further including a minor amount of a metal selected from the group consisting of zinc, aluminum, silver, and copper.

4.  The composite of claim 1 wherein said metal alloy is a eutectic composition having a eutectic temperature of about 100 to 160°C.

5.  The composite of claim 1 wherein said deposition surface includes more than one polymer, each a having a different $T_g$ and wherein regions of conductivity and nonconductivity are provided.

6.  The composite of claim 1 further including a protective coating of a transparent polymer adhered to said metal lacework pattern.

7.  A method of forming an electrically conductive metal/polymer composite according to claim 1, comprising the steps of:
    (a) providing a sheet-like polymeric substrate containing at least one amorphous polymer, having a thickness of about 10 to 1,000 $\mu$m, a glass transition temperature, $T_g$, and at least one deposition surface;
    (b) providing a metal layer on said at least one deposition surface of said sheet-like polymeric substrate, said metal layer comprising an alloy having a thickness of about 0.05 $\mu$m to 2 $\mu$m, said metal layer being conductive in the plane of said polymeric substrate and said metal layer, and said metal having a melting temperature or liquidus greater than the $T_g$ of said polymeric substrate, and
    (c) stretching said metal layer and polymeric substrate at a temperature above the melting point of the metal layer;

wherein said metal layer forms a random lacework pattern including a plurality of core portions interconnected by rivulet portions, said lacework pattern defining a plurality of transparent voids therebetween, said transparent voids permitting the transmission of light therethrough, while said metal layer retains electrical conductivity in the plane of said metal layer after stretching.

8. The method of claim 7 wherein said metal layer and said polymeric substrate are stretched biaxially at a rate of about 150 to 300 percent/minute.

9. The method of claim 7 wherein said metal is provided on said deposition surface by means of sputtering.

10. The method of claim 8 wherein said polymeric substrate is stretched at a temperature within 10°C of said liquidus of said alloy.

FIG. 1

## FIG. 2

## EUROPEAN SEARCH REPORT

European Patent Office

Application Number

EP     92 30 8386

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 130 834 (THE DOW CHEMICAL COMPANY) * page 21, line 25 - page 22, line 9; claims 1,2,11 * | 1-10 | C23C14/20 |
| A | EP-A-0 369 639 (MINNESOTA MINING AND MANUFACTURING COMPANY) * figure 7; example 1 * | 1-10 | |
| A | EP-A-0 380 235 (MINNESOTA MINING AND MANUFACTURING COMPANY) * page 6, line 1 - line 17; figure 3 * | 1-10 | |

TECHNICAL FIELDS SEARCHED (Int. Cl.5 )

C23C

The present search report has been drawn up for all claims

| Place of search | Date of completion of the search | Examiner |
|---|---|---|
| THE HAGUE | 20 JANUARY 1993 | EKHULT H.U. |

EPO FORM 1503 03.82 (P0401)